Europäisches Patentamt

(19) European Patent Office

Office européen des brevets

(11) Publication number: **0 081 977**
A2

## (12) EUROPEAN PATENT APPLICATION

(21) Application number: 82306558.6

(22) Date of filing: 08.12.82

(51) Int. Cl.³: **H 05 K 3/42, H 05 K 3/00**

(30) Priority: 11.12.81 US 329867

(43) Date of publication of application: 22.06.83
Bulletin 83/25

(84) Designated Contracting States: IT

(71) Applicant: **Western Electric Company, Incorporated,
222 Broadway, New York New York 10038 (US)**

(72) Inventor: **Fefferman, Gerald Burt, 15 Holly Drive, Morris
Plains New Jersey 07950 (US)**

(74) Representative: **Johnston, Kenneth Graham et al,
Western Electric Company Limited 5 Mornington Road,
Woodford Green Essex, IG8 OTU (GB)**

(54) **A maskless process for applying a patterned coating.**

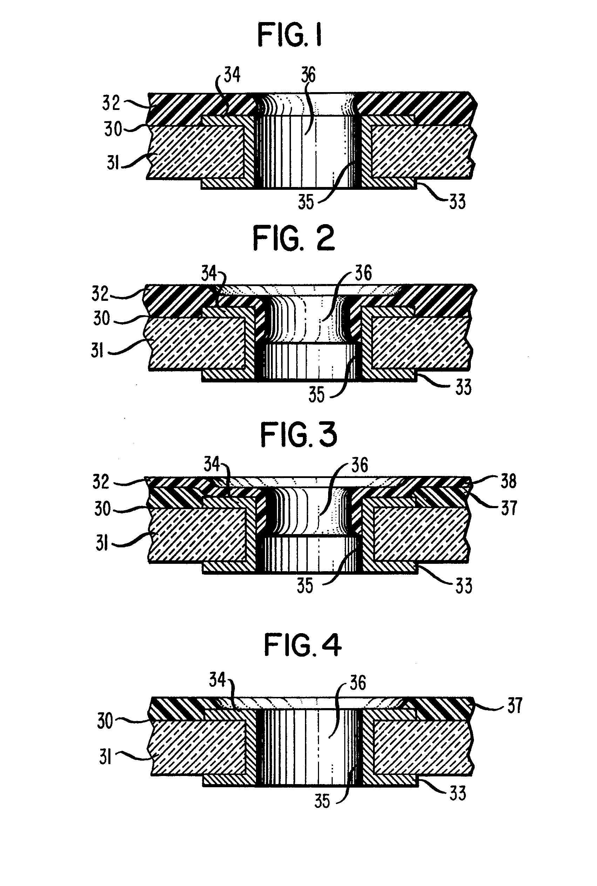

(57) A process for applying a patterned coating to a circuit board
(31) without the use of a patterning mask. A surface (30) of the
circuit board is coated with uncured material (32) having a cure
reaction which is inhibited by the presence of oxygen. The
thickness of the material on land areas (34) surrounding holes
(36) through the circuit board is reduced by causing a portion of
the material to flow into the holes. The material is then exposed, in
the presence of oxygen, to an energy source which advances the
cure reaction only of sublayers (37) of the material which are
isolated from the oxygen by overlayers (38) of the material.
Surface layers of the material, including substantially the entire
thickness of the reduced thickness portions of the layer, remain
uncured, allowing subsequent selective removal of the uncured
portions of the material. (FIG. 3)

# A MASKLESS PROCESS FOR APPLYING

# A PATTERNED COATING

Technical Field

This invention relates to a maskless process for defining and registering a coating on a printed circuit board.

Background of the Invention

In the manufacture of one type of printed circuit board it is desired to provide a layer of material covering one surface of the board but having openings therethrough exposing holes through the boards and annular regions of the boards immediately surrounding the holes. While various techniques exist for accomplishing this, they generally require use of a separate mask for patterning the covering layer. A purpose of this invention is to eliminate the need for the masking process, thereby simplifying the manufacturing procedure.

Summary of the Invention

A surface of a circuit board is wholly coated with the desired covering layer. The layer is then treated to cause portions thereof immediately adjacent to holes through the board to flow into the holes, thereby thinning the layer at these portions. Utilizing the difference in thickness between these portions and the remainder of the covering layer, the thin portions are then removed to expose the areas of the board immediately surrounding the holes.

Brief Description of the Drawings

FIG. 1 is a partial sectional view of a circuit board including a covering layer at the start of the inventive process; and

FIG. 2 through 4 are views similar to that of FIG. 1 showing successive steps of the process.

Detailed Description

A maskless process for applying a coating to a circuit board so as to produce uncoated regions in land areas surrounding holes in the circuit board is herein described. It is at such land areas that an electrical connection is to be effected. Typically, I have found that my process can be employed advantageously for hole sizes approximately 0.5 mm in diameter or greater. Smaller hole sizes than 0.5 mm typically make reduction of the thickness of the material on the land areas more difficult. Nevertheless, use of expedients such as use of suction, allows use of smaller holes.

The initial step in the process is the application to surface 30 of circuit board 31 uncured material 32.

Material 32 is chosen so that upon treatment with a suitable source of energy, for example, ultraviolet light, infrared radiation, an electron beam or heat, it undergoes a modification, such as a chemical reaction, which renders it less susceptible to removal than from an unmodified region. For example, a material 32 is chosen which upon irradiation undergoes a chemical reaction such as polymerization through crosslinking and becomes relatively insoluble in a solvent that rapidly dissolves the unreacted material.

Material 32 is preferably an ultraviolet radiation curable liquid having a cure reaction which is susceptible to inhibition by the presence of oxygen, the degree of inhibition being such as to permit material 32 to remain as a flowable liquid upon exposure to an appropriate first energy source. However, electron beam or thermally curable liquids having the inhibition characteristic are also suitable for this purpose.

Surface 30 should be covered with material 32 to a first thickness which is on the order of twice the thickness of metallized layer 33 constituting land area 34 and sidewalls 35 of plated-through hole 36. Metallized layer 33 typically falls within a thickness range of approximately 25 to 125 μm. Accordingly, surface 30 would be covered by uncured material 32 to a thickness ranging between 60 μm and 200 μm.

Several different techniques may be employed to apply uncured material 32 to surface 30, e.g., screen printing with the screen not having any pattern therein, a curtain coating process, roller coating, spray coating, and the use of a threaded draw-down bar.

Depending on the thickness of material 32 applied to surface 30 and, in particular, whether plated-through hole 36 receives so much material 32 as to become plugged, it may be necessary to implement an optional step. This step involves the removal of at least a portion of any uncured material 32 resident in hole 36 so as to provide a cavity to accept further uncured material 32 flowing from land area 34 upon implementation of a subsequent step. In practice this step is most easily implemented by the application of suction to the underside of circuit board 31.

After circuit board 31 has material 32 applied thereto the next step is to diminish the amount of material 32 on land areas 34. The reduction in thickness of material 32 is accomplished by allowing a portion of material 32 on land areas 34 to flow into plated-through holes 36, as shown in FIG. 2. The amount of material 32 flowing into holes 36 is preferably limited such that the thickness of material 32 on sidewalls 35 and any material 32 which might bridge holes 36 is no greater than the thickness of material 32 which will remain uncured by oxygen inhibition. This thickness of material 32 which will remain uncured typically ranges in thickness from approximately 12 to 50 μm.

Although the thickness of uncured material 32 on land areas 34 is diminished due to the presence of holes 36, if material 32 is excessively viscous, that is, has a viscosity greater than approximately 10,000 centipoise, or if holes 36 are unusually small, that is, having a diameter less than approximately 0.5 mm, it is possible that excessive time periods for thickness diminution will occur. To avoid this, the material 32 can be heated to reduce its viscosity.

Having diminished the thickness of material 32 on land areas 34 to a thickness no greater than the thickness of a layer which will remain uncured due to oxygen inhibition, the next step is to expose material 32 to a source of energy (not shown) to initiate the cure reaction. The type of energy source that is employed is dependent upon the type of material 32 that is used. For instance, if material 32 is an ultraviolet curable substance the energy source is either an ultraviolet radiation source or an electron beam source. If material 32 is a thermally curable substance, the energy source is a heat source.

Whichever type of material 32 and energy source that is employed, material 32 is exposed to such source for a time sufficient to cause an advancement in its cure reaction in sublayer 37, as shown in FIG. 3, while surface layer 38 remains uncured due to oxygen inhibition. The amount of oxygen in ambient air is sufficient to cause such inhibition.

Not only the environment but also the dose of the exposure from the first energy source and the intensity of the energy influence the degree of inhibition. The dose, that is, the total energy supplied per unit volume, should be adequate to produce sufficient advancement in cure in sublayer 37. For example, for material undergoing free-radical polymerization, such as acrylates, actinic doses in the range of 20 to 2000 millijoules per square centimeter are typically employed.

Excessive intensity generally counteracts the inhibiting effect of the environment. For example, actinic intensities greater than 100 milliwatts per square centimeter generally produce free radicals in surface layer 38 at a rate faster than oxygen in air reacts with these radicals to inhibit the reaction. Thus, to increase the extent of inhibition either the intensity is reduced or the oxygen concentration in the environment is increased.

Following exposure, uncured surface layer 38 is removed with a solvent. The choice of solvent is dependent upon the type of material 32 that is employed. For some acrylated epoxy based materials 32, solvents such as 1,1,1-trichloroethane and diethylene glycol monobutyl ether are used. The solvent is then removed, as by draining and drying.

If the sublayer 37 had not been completely cured during the exposure to the curing energy source, a further application of energy is the made to complete the curing process.

In a first specific embodiment of my method, uncured material 32 was a solder mask material SM-15-BTL manufactured by Dynachem Corporation. This material 32 was screen printed through a 135 mesh polyester screen having perimeter definition only. Uncured material 32 was applied to a thickness of 60 μm. A heating step caused partial flow of the material into holes through the board resulting in the thickness of material 32 on land areas 34 being diminished to less than 25 μm. Circuit board 31 was then exposed to a 1,000 watt high pressure mercury vapor lamp focused over a 30 cm diameter circle. The exposure was for a period of five seconds. The cure-inhibited surface layer 38 was removed by immersing circuit board 31 in a 1,1,1-trichloroethane solvent for 30 seconds. Circuit board 31 was dried by compressed air. Following the drying step, circuit board 31 was heated in a forced air oven for ten minutes at a temperature of 100°C. This heating step was employed to drive off any solvent which may have been absorbed. Circuit board 31 then was exposed to two focused linear 200 watt per inch medium pressure mercury vapor lamps. One pass was made under the lamps at a rate of ten feet per minute. In this embodiment of my process the resulting uncoated region surrounding hole 36 was an annular ring concentric with hole 36, having an internal radius equal to the hole radius and an external radius 200 μm greater than the radius of hole 36.

In another embodiment, after screen printing of the coating material 32, any excess material in the holes 36 was blown out by an air stream applied from the uncoated side of the board.

In another embodiment of my method, uncured material 32 contained the following ingredients in the amounts shown below. Material 32 for this embodiment will be hereinafter referred to as Formulation A.

FORMULATION A

| Ingredient | Amount by unit weight |
|---|---|
| Celrad ® 3700 | 30 |
| Hycar ® VTBN 1300X22 | 20 |
| SR-349 | 30 |
| QM-589 | 40 |
| Irgacure 651 | 1 |
| Magenta pigment conc. #9R75 | 3 |

Celrad 3700 obtained from Celanese Plastics and Specialties Company essentially consists of an acrylated epoxy prepared by reacting acrylic acid with a bis-phenol A epoxy resin having an epoxy equivalent weight of 190-200. Hycar VTBN 1300X22, sold by the B.F. Goodrich Chemical Group, essentially consists of an acrylate terminated acrylonitrile butadiene liquid rubber having a molecular weight of approximately 3500, with an acrylonitrile content of approximately 17 percent and an acrylate content of approximately 1.85 per molecule. SR-349, obtained from Sartomer Company, essentially consists of an ethoxylated bis-phenol A diacrylate. QM-589, available from the Rohm and Haas Company, essentially consists of isobornyl acrylate. Irgacure 651 is a photoinitiator from the Ciba-Geigy Corporation having the chemical name 2,2-dimethoxy phenyl acetophenone. Magenta pigment concentrate #9R75, obtained from Penn Color, Inc., contains a quinacridone type pigment dispersed in trimethylolpropane triacrylate.

Formulation A is prepared as follows: In a common vessel is added the above ingredients in the amounts shown above and in the order listed. The vessel was heated to approximately 50-60 degrees centigrade by means of a water bath. The mixture was then stirred for 10-15 minutes at that temperature by means of a mechanical stirrer. The mixture was then cooled to room temperature and allowed to stand for eight hours before using to allow entrapped air bubbles to escape. Alternatively, the cooled mixture was placed in a vacuum chamber at 10-20 mm mercury pressure for five minutes to remove the entrapped air bubbles.

Formulation A was applied to circuit board 31 to a thickness of 80 $\mu$m by a manually operated draw-down bar having 40 threads per inch. Any excess material 32 in holes 36 was drawn out by a vacuum from the noncoated side of circuit board 31. Thereafter circuit board 31 was heated to diminish the thickness of uncured material 32 on land areas 34 to less than 30 $\mu$m. Circuit board 31 was then exposed for 20 seconds to a 1,000 watt high pressure mercury vapor lamp focused over a 30 cm diameter surface. Cure-inhibited surface layer 38 was removed by immersion in diethylene glycol monobutyl ether for a period of three minutes. Circuit board 31 was dried by compressed air. Thereafter, circuit board 31 was heated in a forced air oven for a period of 30 minutes at 100°C. Finally, circuit board 31 was exposed to two focused linear 200 watt per inch medium pressure mercury vapor lamps with two passes being made at a speed of ten feet per minute. In this embodiment of my process, the uncoated region had an external radius 175 $\mu$m greater than the radius of hole 36.

In a further embodiment of my method, uncured material 32 consists of the following ingredients in the amounts shown below. Material 32 for this embodiment will be hereinafter referred to as Formulation B.

FORMULATION B

| Ingredient | Amount by unit weight |
|---|---|
| Celrad ® 3702 | 50 |
| Hycar ® VTBN 1300X23 | 30 |
| QM-589 | 50 |
| 2 2-diethoxyacetophenone | 4 |
| Magenta pigment conc. #9R75 | 3 |
| Modaflow $^R$ | 1 |

Celrad 3702, from Celanese Plastics and Specialties Company, essentially consists of an acrylate derived from reacting bis-phenol A epoxide with acrylic acid and an unknown diacid. Hycar VTBN 1300X23 from B. F. Goodrich Chemical Group, is structurally similar to Hycar VTBN 1300X22 but having approximately 2.35 acrylate groups per molecule. The photoinitiator is 2,2-diethoxyacetophenone from Polysciences, Inc. Modaflow is a flow modifier obtained from the Monsanto Industrial Chemicals Company.

Formulation B was prepared in the same manner as Formulation A.

Formulation B was applied to circuit board 31 to a thickness of 150 μm by a manually operated draw-down bar having 18 threads per inch. Any excess material 32 in holes 36 was drawn out by a vacuum from the noncoated side of circuit board 31. Thereafter, circuit board 31 was heated to diminish the thickness of uncured material 32 on land areas 34 to less than 35 μm. Circuit board 31 was then exposed for 40 seconds to a 1,000 watt high pressure mercury vapor lamp focused over a 30 cm diameter surface. Cure-inhibited surface layer 38 was removed by spraying diethylene glycol monobutyl ether on circuit board 31 for a period of three minutes. Circuit board 31 was heated in a forced air oven for a period of 30 minutes at 100°C. Finally, circuit board 31 was exposed to two focused linear 200 watt per inch medium pressure mercury vapor lamps with two passes being made at a speed of ten feet per minute. In this embodiment of my process, the uncoated region surrounding hole 36 had an external radius 150 μm greater than the radius of hole 36.

In another embodiment of my process, Formulation B was applied to circuit board 31 to a thickness of 80 μm by a KMC Corporation Model KM-CC-H-1-22 curtain coater operating at a belt speed of 300 feet per minute. In this embodiment, it was unnecessary to remove excess material from holes 36 since no excess material entered the holes. In addition, it was not necessary to heat circuit board 31 to reduce the viscosity of material 32 since material 32 surrounding holes 36 is sufficiently diminished by virtue of the curtain coating application. The material thickness surrounding holes 36 was less than 35 μm. Circuit board 31 then was exposed for 20 seconds to a 1,000 watt high pressure mercury vapor lamp focused over a 30 cm diameter surface. Cure-inhibited surface layer 38 was removed by immersion in diethylene glycol monobutyl ether for a period of three minutes. Circuit board 31 was dried by compressed air and thereafter was heated in a forced air oven for a period of 30 minutes at 100°C. Finally, circuit board 31 was exposed to two focused linear 200 watt per inch medium pressure mercury vapor lamps with two passes being made at a speed of ten feet per minute. In this embodiment of my process, the uncoated region surrounding hole 36 had an external radius 175 μm greater than the radius of hole 36.

CLAIMS

1. A process for applying a coating to a circuit board (31) so as to produce uncoated regions on land areas (34) surrounding holes (36) in said board, characterized by the steps of:

applying to a surface (30) of said board and uncured material layer (32) having a cure reactions which is inhibited by the presence of oxygen,

reducing the thickness of those portions of said layer on said land areas by causing some of the layer material at those portions to flow into said holes,

exposing said layer, in the presence of oxygen, to an energy source for advancing the cure reaction only of sublayers (37) of the material which are isolated from the oxygen by overlayers (38) of the material, such overlayers, including substantially the entire thickness of the reduced thickness portions of said layer, remaining substantially uncured, and

selectively removing said uncured portions of the material.

2. The process of claim 1 including the step of heating said material to reduce its viscosity for promoting its flow into said holes.

## FIG. 1

## FIG. 2

## FIG. 3

## FIG. 4